# EUROPEAN PATENT APPLICATION

(11) **EP 4 512 855 A1**
(43) Date of publication of application: **26.02.2025**
(21) Application number: 23839904.2
(22) Date of filing: 10.07.2023
(51) Int. Cl.: C08K 5/00, C08K 5/5419, C08K 5/14, C08K 5/23, C08L 23/08, C08J 5/18, H01L 23/29

(54) **CROSSLINKING AGENT COMPOSITION FOR OLEFIN-BASED COPOLYMER, ENCAPSULANT COMPOSITION FOR OPTICAL DEVICE COMPRISING SAME, AND ENCAPSULANT FILM FOR OPTICAL DEVICE**

(30) Priority: 11.07.2022 KR 20220085134
(71) Applicant: LG Chem, Ltd., Yeongdeungpo-gu Seoul 07336 (KR)
(72) Inventor: LEE, Si Jung, Daejeon 34122 (KR); LEE, Eun Jung, Daejeon 34122 (KR); GONG, Jin Sam, Daejeon 34122 (KR); PARK, Sang Eun, Daejeon 34122 (KR); LEE, Jin Kuk, Daejeon 34122 (KR); KIM, Jong Gil, Daejeon 34122 (KR)
(74) Representative: Hoffmann Eitle
(86) International application number: PCT/KR2023/009767
(87) International publication number: WO 2024/014811

(57) **Abstract**

The present invention relates to a crosslinking agent composition for an olefin-based copolymer, an encapsulant composition for an optical device, an encapsulant film for an optical device, and an optoelectronic device, wherein a compound of Formula 1 is applied in the crosslinking agent composition for an olefin-based copolymer or an encapsulant composition for an optical device, including an olefin-based copolymer, as a crosslinking auxiliary agent, thereby forming an encapsulant composition for an optical device and an encapsulant film for an optical device, showing excellent productivity and high volume resistance and light transmittance.

## Description

### TECHNICAL FIELD

This application claims the benefit of Korean Patent Application No. 10-2022-0085134, filed on July 11, 2022, in the Korean Intellectual Property Office, the contents of which are incorporated herein by reference.

The present invention relates to a crosslinking agent composition for an olefin-based copolymer, an encapsulant composition for an optical device comprising the same and an encapsulant film for an optical device, and relates to a crosslinking agent composition for an olefin-based copolymer, used in an encapsulant composition for an optical device including an olefin-based copolymer, an encapsulant composition for an optical device, comprising the crosslinking agent, an encapsulant film for an optical device, manufactured using the same, and an optical device module comprising the encapsulant film for an optical device.

### BACKGROUND ART

As global environmental problems, energy problems, etc. get worse and worse, solar cells receive attention as a clean energy generating means without fear of exhaustion. If solar cells are used outside such as the roof of a building, generally, a module type is used. In order to obtain a crystalline solar cell module when manufacturing a solar cell module, protection sheet for solar cell module (surface side transparent protection member)/solar cell encapsulant/crystalline solar cell device crystalline solar cell device/solar cell encapsulant/protection sheet for solar cell module (back side protection member) are stacked in order. Meanwhile, in order to manufacture a thin film-based solar cell module, thin film-type solar cell device/solar cell encapsulant/protection sheet for solar cell module (back side protection member) are stacked in order.

As the solar cell encapsulant, generally, an ethylene/vinyl acetate copolymer or an ethylene/alpha-olefin copolymer, etc. is used. In addition, in the solar cell encapsulant, a light stabilizer is generally included as an additive considering the requirement on climate-resistance for a long time. In addition, considering the adhesiveness of a transparent surface side protection member or a back side protection member represented by glass, a silane coupling agent is commonly included in the solar cell encapsulant.

Particularly, an ethylene/vinyl acetate copolymer (EVA) sheet has been widely used, because transparency, flexibility and adhesiveness are excellent. An ethylene·vinyl acetate copolymer (EVA) film has been widely used, because transparency, flexibility and adhesiveness are excellent. However, if an EVA composition is used as the constituent material of a solar cell encapsulant, it has been apprehended that components such as an acetic acid gas generated by the decomposition of EVA might influence a solar cell device.

An ethylene/alpha-olefin copolymer has no problems of a resin on hydrolysis and may solve the problems of deteriorating lifetime or reliability. However, since the ethylene/alpha-olefin copolymer does not include a polar group in the resin, miscibility with a polar crosslinking auxiliary agent included as the constituent material of the conventional solar cell encapsulant, has been deteriorated, it took a long time for soaking, and there were problems with productivity.

As described above, the development of a crosslinking auxiliary agent that could improve the productivity of a solar cell encapsulant including an ethylene/alpha-olefin copolymer which could be usefully utilized as a material having excellent volume resistance and requiring high insulation, such as a solar cell encapsulant, is still required.

### [Prior Art Document]

### [Patent Document]

(Patent Document 1) Korean Laid-open Patent No. 2018-0063669

### DETAILED DESCRIPTION OF THE INVENTION

### TECHNICAL PROBLEM

A task to solve in the present invention is to provide a crosslinking agent composition for an olefin-based copolymer, used for crosslinking an olefin-based copolymer and including a crosslinking auxiliary agent having excellent miscibility with the olefin-based copolymer.

Another task to solve in the present invention is to provide an encapsulant composition for an optical device, including a crosslinking auxiliary agent having excellent miscibility with an olefin-based copolymer and showing high volume resistance and excellent insulation thereby.

Another task to solve in the present invention is to provide an encapsulant film for an optical device, manufactured by using the encapsulant composition for an optical device.

Another tasks to solve in the present invention is to provide an optoelectronic device including the encapsulant film for an optical device.

### TECHNICAL SOLUTION

To solve the above tasks, the present invention provides a crosslinking agent composition for an olefin-based copolymer, an encapsulant composition for an optical device, an encapsulant film for an optical device, and an optoelectronic device.
[1] The present invention provides a crosslinking agent composition for an olefin-based copolymer, comprising a compound of Formula 1. 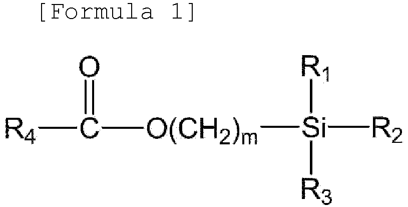 In Formula 1, R₁ to R₄ are each independently alkyl of 1 to 20 carbon atoms or alkenyl of 2 to 20 carbon atoms, and m is an integer of 1 to 20.
[2] The present invention provides the crosslinking agent composition for an olefin-based copolymer according to [1], wherein R₁ to R₄ are each independently alkenyl of 2 to 8 carbon atoms, and m is an integer of 1 to 12.
[3] The present invention provides the crosslinking agent composition for an olefin-based copolymer according to [1] or [2], wherein R₁ to R₄ are each independently alkenyl of 2 to 8 carbon atoms, having a double bond at the terminal thereof.
[4] The present invention provides the crosslinking agent composition for an olefin-based copolymer according to any one among [1] to [3], wherein the crosslinking auxiliary compound of Formula 1 is 3-(triallylsilyl)propyl acrylate.
[5] The present invention provides the crosslinking agent composition for an olefin-based copolymer according to [4], further comprising a second crosslinking auxiliary compound in addition to the crosslinking auxiliary compound of Formula 1.
[6] The present invention provides the crosslinking agent composition for an olefin-based copolymer according to [5], wherein a weight ratio of the crosslinking auxiliary compound of Formula 1 and the second crosslinking auxiliary compound is 1: 0.2 to 1: 9.
[7] The present invention provides the crosslinking agent composition for an olefin-based copolymer according to [5] or [6], wherein the second crosslinking auxiliary compound comprises one or more selected from the group consisting of triallyl isocyanurate, triallyl cyanurate, diallyl phthalate, diallyl fumarate, diallyl maleate, ethylene glycol diacrylate, ethylene glycol dimethacrylate and trimethylolpropane trimethacrylate.
[8] The present invention provides the crosslinking agent composition for an olefin-based copolymer according to any one among [1] to [7], wherein the crosslinking agent is one or two or more selected from the group consisting of an organic peroxide, a hydroperoxide and an azo compound.
[9] The present invention provides the crosslinking agent composition for an olefin-based copolymer according to any one among [1] to [8], wherein the crosslinking agent is one or more selected from the group consisting of t-butylcumylperoxide, di-t-butyl peroxide, di-cumyl peroxide, 2,5-dimethyl-2,5-di(t-butylperoxy)hexane, 2,5-dimethyl-2,5-di(t-butylperoxy)-3-hexyne, cumene hydroperoxide, diisopropyl benzene hydroperoxide, 2,5-dimethyl-2,5-di(hydroperoxy)hexane, t-butyl hydroperoxide, bis-3,5,5-trimethylhexanoyl peroxide, octanoyl peroxide, benzoyl peroxide, o-methylbenzoyl peroxide, 2,4-dichlorobenzoyl peroxide, t-butylperoxy isobutyrate, t-butylperoxy acetate, t-butylperoxy-2-ethylhexylcarbonate (TBEC), t-butylperoxy-2-ethylhexanoate, t-butylperoxy pyvalate, t-butylperoxy octoate, t-butylperoxyisopropyl carbonate, t-butylperoxybenzoate, di-t-butylperoxyphthalate, 2,5-dimethyl-2,5-di(benzoylperoxy)hexane, 2,5-dimethyl-2,5-di(benzoylperoxy)-3-hexyne, methyl ethyl ketone peroxide, cyclohexanone peroxide, azobisisobutyronitrile and azobis(2,4-dimethylvaleronitrile).
[10] The present invention provides the crosslinking agent composition for an olefin-based copolymer according to any one among [1] to [9], wherein the silane coupling agent is one or more selected from the group consisting of N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, γ-methacryloxypropyltrimethoxysilane, vinyltrimethoxysilane, vinyltriethoxysilane, 3-methacryloxypropyl methyldimethoxysilane, 3-methacryloxypropyl methyldiethoxysilane, 3-methacryloxypropyl triethoxysilane, and p-styryl trimethoxysilane.
[11] In addition, the present invention provides an encapsulant composition for an optical device, comprising an olefin-based polymer; and the crosslinking agent composition for an olefin-based copolymer according to any one among [1] to [10].
[12] The present invention provides the encapsulant composition for an optical device according to [11], wherein the olefin-based copolymer is an ethylene alpha-olefin copolymer.
[13] In addition, the present invention provides an encapsulant film for an optical device, comprising a structure derived from an olefin-based copolymer and a compound of Formula 1. 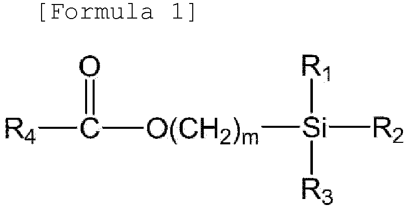 In Formula 1, R₁ to R₄ are each independently alkyl of 1 to 20 carbon atoms or alkenyl of 2 to 20 carbon atoms, and m is an integer of 1 to 20.
[14] In addition, the present invention provides an optoelectronic device comprising an optical device and the encapsulant film for an optical device according to [13].

### ADVANTAGEOUS EFFECTS

The crosslinking agent composition for an olefin-based copolymer of the present invention includes a compound having excellent miscibility with an olefin-based copolymer as a crosslinking auxiliary agent and has rapid soaking in an olefin-based copolymer, and the encapsulant composition for an optical device obtained using the same shows excellent volume resistance and light transmittance and may be widely used for various uses in electrical and electronic industries.

### MODE FOR CARRYING OUT THE INVENTION

Hereinafter, the present invention will be described in more detail to assist the understanding of the present invention.

It will be understood that words or terms used in the present disclosure and claims shall not be interpreted as the meaning defined in commonly used dictionaries. It will be further understood that the words or terms should be interpreted as having a meaning that is consistent with their meaning in the context of the relevant art and the technical idea of the invention, based on the principle that an inventor may properly define the meaning of the words or terms to best explain the invention.

Each substituent defined in the present disclosure will be explained in detail below.

The term "alkyl" used in the present disclosure means the hydrocarbon residual group of a linear or branched chain, unless otherwise referred to.

The term "alkenyl" used in the present disclosure means the alkenyl group of a linear or branched chain, unless otherwise referred to.

The branched chain may be alkyl of 1 to 20 carbon atoms or alkenyl of 2 to 20 carbon atoms.

### [Crosslinking Agent Composition for Olefin-based Copolymer]

The crosslinking agent composition for an olefin-based copolymer comprises: a crosslinking agent; a silane coupling agent; and a crosslinking auxiliary compound represented by Formula 1.

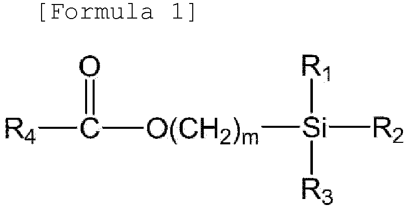

In Formula 1, R₁ to R₄ are each independently alkyl of 1 to 20 carbon atoms or alkenyl of 2 to 20 carbon atoms, and m is an integer of 1 to 20.

In Formula 1, R₁ to R₄ may be each independently alkenyl of 2 to 8 carbon atoms, and m is an integer of 1 to 12.

In addition, in Formula 1, R₁ to R₄ may be each independently alkenyl of 2 to 8 carbon atoms, having a double bond at the terminal thereof.

In addition, the crosslinking agent composition for an olefin-based copolymer according to an embodiment of the present invention may particularly include 3-(triallylsilyl)propyl acrylate represented by Formula 2 below, as the compound of Formula 1.

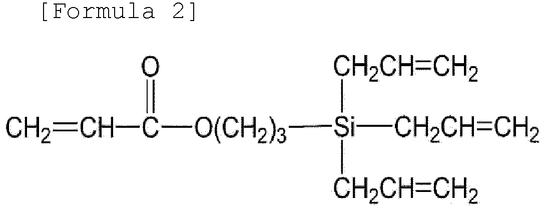

The compound of Formula 1, included in the crosslinking agent composition for an olefin-based copolymer of the present invention may be included in the crosslinking agent composition for an olefin-based copolymer as the crosslinking auxiliary agent, and the compound of Formula 1 may show excellent miscibility with an olefin-based copolymer and may show a rapid soaking rate. Through this, the absorption rate of a crosslinking auxiliary agent which showed the slowest absorption rate in an olefin-based copolymer among a crosslinking agent, a silane coupling agent and a crosslinking auxiliary agent, included in the conventional crosslinking agent composition used for an olefin-based copolymer, may be improved, and the soaking time of the crosslinking agent composition may be reduced, short soaking time may be accomplished, and excellent crosslinking properties on the olefin-based copolymer may be shown.

If the crosslinking agent composition for an olefin-based copolymer of the present invention, including the compound of Formula 1 is applied as a crosslinking agent in an encapsulant composition for an optical device, including an olefin-based copolymer, the encapsulant composition for an optical device may show a high degree of crosslinking, and high volume resistance and light transmittance.

In addition, the crosslinking agent composition for an olefin-based copolymer may further include a second crosslinking auxiliary compound in addition to the crosslinking auxiliary compound of Formula 1 as a crosslinking auxiliary agent.

As the second crosslinking auxiliary agent, various crosslinking auxiliary agents well-known in the art can be used, for example, a compound containing at least one or more unsaturated groups such as an allyl group and a (meth)acryloxy group may be used.

The second crosslinking auxiliary agent may be a crosslinking auxiliary agent containing at least one or more unsaturated groups, and may be, for example, a poly allyl compound such as triallyl isocyanurate (TAIC), triallyl cyanurate, diallyl phthalate, diallyl fumarate, and diallyl maleate, and the compound containing the (meth)acryloxy group may be, for example, a poly(meth)acryloxy compound such as ethylene glycol diacrylate, ethylene glycol dimethacrylate and trimethylolpropane trimethacrylate, without specific limitation.

If the crosslinking agent composition for an olefin-based copolymer according to an embodiment of the present invention further includes the second crosslinking auxiliary compound in addition to the compound of Formula 1, a weight ratio of the compound of Formula 1 to the second crosslinking auxiliary compound may be 1: 0.20 to 9.0, particularly, 1: 0.20 to 6.0, 1: 0.20 to 5.0, 1: 0.20 to 4.0, 1: 0.20 to 3.7, 1: 0.25 to 5.0, 1: 0.25 to 4.0, 1: 0.25 to 3.7, 1: 0.25 to 3.5, 1: 0.25 to 3.2, 1: 0.25 to 3.0, 1: 0.3 to 3.7, 1: 0.3 to 3.5, 1: 0.3 to 3.2, 1: 0.3 to 3.0, or 1: 0.33 to 3.0.

If the crosslinking agent composition for an olefin-based copolymer according to an embodiment of the present invention includes the compound of Formula 1 and the second crosslinking auxiliary compound together, an even higher degree of crosslinking may be accomplished in contrast to a case of including only the same amount of the compound of Formula 1, and if applied to an encapsulant composition for an optical device, the encapsulant composition for an optical device may show high volume resistance and may satisfy excellent light transmittance and adhesiveness.

If the compound of Formula 1 and the second crosslinking auxiliary agent are included together, and if the ratio of the second crosslinking auxiliary agent to the compound of Formula 1 is increased to a certain degree or more, the degree of crosslinking may increase, and vulcanization properties may be improved, and if the ratio of the second crosslinking auxiliary agent to the compound of Formula 1 is decreased, the degree of reducing a soaking rate may be reduced. Accordingly, an appropriate ratio may be determined in the range according to the physical properties to show. If the ratio of the second crosslinking auxiliary agent is excessive, the improving effect of the soaking rate by the use of the compound of Formula 1 may be difficult to show, and if the ratio of the second crosslinking auxiliary agent is too small, it is difficult to appropriately show the additional effect which can be achieved by the mixing of the second crosslinking auxiliary agent.

In the crosslinking agent composition for an olefin-based copolymer according to an embodiment of the present invention, in order to achieve a reduced soaking time of a crosslinking agent together with excellent vulcanization properties, degree of crosslinking and volume resistance, the compound of Formula 1 and the second crosslinking auxiliary compound may be included together, and the compound of Formula 1 and the second crosslinking auxiliary compound may be included in a weight ratio of 1: 0.20 to 3.7, particularly, 1: 0.25 to 3.7, 1: 0.25 to 3.5, 1: 0.25 to 3.2, 1: 0.25 to 3.0, 1: 0.3 to 3.7, 1: 0.3 to 3.5, 1: 0.3 to 3.2, 1: 0.3 to 3.0, or 1: 0.33 to 3.0.

The crosslinking agent may use various crosslinking agents well-known in the art as long as they are crosslinkable compounds that may initiate radical polymerization or form crosslinking bonds, and may use one or two or more selected from the group consisting of an organic peroxide, a hydroperoxide and an azo compound.

In addition, in an embodiment of the present invention, the crosslinking agent may particularly be an organic peroxide.

The organic peroxide may be an organic peroxide having a one-hour half-life temperature of 120 to 135°C, for example, 120 to 130°C, 120 to 125°C, particularly, 121°C. The "one-hour half-life temperature" means a temperature at which the half-life of the crosslinking agent becomes one hour. According to the one-hour half-life temperature, the temperature at which radical initiation reaction is efficiently performed may become different. Therefore, in case of using the organic peroxide having the one-hour half-life temperature in the above-described range, radical initiation reaction, that is, crosslinking reaction in a lamination process temperature for manufacturing an optoelectronic device may be effectively performed.

The crosslinking agent may include one or more selected from the group consisting of dialkyl peroxides such as t-butylcumylperoxide, di-t-butyl peroxide, di-cumyl peroxide, 2,5-dimethyl-2,5-di(t-butylperoxy)hexane, and 2,5-dimethyl-2,5-di(t-butylperoxy)-3-hexyne; hydroperoxides such as cumene hydroperoxide, diisopropyl benzene hydroperoxide, 2,5-dimethyl-2,5-di(hydroperoxy)hexane, and t-butyl hydroperoxide; diacyl peroxides such as bis-3,5,5-trimethylhexanoyl peroxide, octanoyl peroxide, benzoyl peroxide, o-methylbenzoyl peroxide, and 2,4-dichlorobenzoyl peroxide; peroxy esters such as t-butylperoxy isobutyrate, t-butylperoxy acetate, t-butylperoxy-2-ethylhexylcarbonate (TBEC), t-butylperoxy-2-ethylhexanoate, t-butylperoxy pyvalate, t-butylperoxy octoate, t-butylperoxyisopropyl carbonate, t-butylperoxybenzoate, di-t-butylperoxyphthalate, 2,5-dimethyl-2,5-di(benzoylperoxy)hexane, and 2,5-dimethyl-2,5-di(benzoylperoxy)-3-hexyne; ketone peroxides such as methyl ethyl ketone peroxide and cyclohexanone peroxide, lauryl peroxide, and azo compounds such as azobisisobutyronitrile and azobis(2,4-dimethylvaleronitrile), without limitation.

The silane coupling agent may use, for example, one or more selected from the group consisting of N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, γ-methacryloxypropyltrimethoxysilane (MEMO), vinyltrimethoxysilane, vinyltriethoxysilane, 3-methacryloxypropyl methyldimethoxysilane, 3-methacryloxypropyl methyldiethoxysilane, 3-methacryloxypropyl triethoxysilane, and p-styryl trimethoxysilane.

The crosslinking agent composition for an olefin-based copolymer may include 20 to 80 parts by weight of the crosslinking agent, 5 to 30 parts by weight of the silane coupling agent, and 10 to 60 parts by weight of the crosslinking auxiliary agent including the crosslinking auxiliary agent of Formula 1. The amounts of the components may mean relative ratios among the weights of the components included in the crosslinking agent composition for an olefin-based copolymer.

The crosslinking agent may be included in the crosslinking agent composition for an olefin-based copolymer in 20 to 80 parts by weight, particularly, 20 parts by weight or more, 25 parts by weight or more, 30 parts by weight or more, 35 parts by weight or more, or 40 parts by weight or more to 80 parts by weight or less, 75 parts by weight or less, or 70 parts by weight or less. If the amount included of the crosslinking agent is too small, it is difficult to carry out a crosslinking reaction if using the olefin-based copolymer, and if the amount included of the crosslinking agent is too large, the volume resistance of an encapsulant for an optical device, manufactured by using the olefin-based copolymer may be reduced. Accordingly, if the crosslinking agent is included in the crosslinking agent composition for an olefin-based copolymer in the above-described range, the encapsulant composition for an optical device, using the same may carry out an appropriate crosslinking reaction to form an encapsulant for an optical device, and the encapsulant for an optical device thus manufactured may show high volume resistance.

The silane coupling agent may be included in the crosslinking agent composition for an olefin-based copolymer in 5 to 30 parts by weight, particularly, 5 parts by weight or more, 6 parts by weight or more, 7 parts by weight or more, or 8 parts by weight or more to 20 parts by weight or less, 19 parts by weight or less, or 18 parts by weight or less. If the amount included of the silane coupling agent is too small, and if the olefin-based copolymer is used, adhesiveness of the encapsulant composition for an optical device to a substrate, for example, the adhesiveness of the encapsulant composition for an optical device to a glass substrate is low, and appropriate performance as the encapsulant for an optical device is difficult to show. If the amount included of the silane coupling agent is too large, the volume resistance of the encapsulant for an optical device may be reduced inappropriately. If the silane coupling agent is included in the crosslinking agent composition for an olefin-based copolymer in the above-described range, the encapsulant composition for an optical device, using the same may show excellent adhesiveness to the substrate of the optical device or a glass substrate where the optical device is positioned, the penetration of moisture may be effectively prevented, the optical device may maintain excellent performance for a long time, and the encapsulant for an optical device may show high volume resistance.

The total amount of the crosslinking auxiliary agent including the crosslinking auxiliary compound of Formula 1, i.e., the crosslinking auxiliary compound of Formula 1 as the crosslinking auxiliary agent, or the crosslinking auxiliary compound of Formula 1 and the second crosslinking auxiliary compound, included in the crosslinking agent composition for an olefin-based copolymer may be 10 to 60 parts by weight, particularly, 11 parts by weight or more, 12 parts by weight or more, or 13 parts by weight or more to 60 parts by weight or less, 55 parts by weight or less, or 50 parts by weight or less.

The olefin-based copolymer to which the crosslinking agent composition for an olefin-based copolymer may be applied, may satisfy, for example, a) a density of 0.85 to 0.90 g/cc, and (b) a melt index of 0.1 to 100 g/10 min.

The (a) density of the olefin-based copolymer may particularly be 0.850 g/cc or more, 0.855 g/cc or more, 0.860 g/cc or more, 0.865 g/cc or more, or 0.870 g/cc or more to 0.900 g/cc or less, 0.895 g/cc or less, 0.890 g/cc or less, 0.885 g/cc or less, or 0.880 g/cc or less. If the density of the olefin-based copolymer is too high, the light transmittance of an encapsulant composition for an optical device, using the same and an encapsulant for an optical device, manufactured by using the same may be reduced due to the crystal phase included in the olefin-based copolymer, but if the olefin-based copolymer satisfies the above-described density range, high light transmittance may be shown.

The (b) melt index of the olefin-based copolymer may be 0.1 g/10 min or more, 0.5 g/10 min or more, 1.0 g/10 min or more, 1.5 g/10 min or more, 2.0 g/10 min or more, 2.5 g/10 min or more, 3.0 g/10 min, or 3.5 g/10 min or more to 100 g/10 min or less, 95 g/10 min or less, 90 g/10 min or less, 85 g/10 min or less, 80 g/10 min or less, 75 g/10 min or less, or 70 g/10 min or less, 60 g/10 min or less, or 50 g/10 min or less. If the melt index of the olefin-based copolymer is deviated from the above-described range and too low or high, there may be problems in that the moldability of the encapsulant composition for an optical device may become poor, and stable extrusion may become difficult. However, if the olefin-based copolymer satisfies the above melt index range, the moldability of the encapsulant composition for an optical device may be excellent, and an encapsulant for an optical device, and an encapsulant sheet for an optical device could be extruded stably.

The olefin-based copolymer to which the crosslinking agent composition for an olefin-based copolymer according to an embodiment of the present invention is applied, may particularly be an ethylene/alpha-olefin copolymer.

Generally, the density of the ethylene/alpha-olefin copolymer may be influenced by the type and amount of a monomer used during polymerization, the degree of polymerization, or the like, and in the case of a copolymer, the influence by the amount of a comonomer is large. With the increase of the amount of the comonomer, an ethylene/alpha-olefin copolymer having a low density may be prepared, and the amount of the comonomer introducible in the copolymer may be dependent on the intrinsic copolymerization properties of a catalyst.

The ethylene/alpha-olefin copolymer to which the crosslinking agent composition for an olefin-based copolymer of the present invention is applied, may show a low density and excellent processability as described above.

The ethylene/alpha-olefin copolymer is prepared by copolymerizing ethylene and an alpha-olefin-based monomer, and in this case, the alpha-olefin which means a moiety derived from an alpha-olefin-based monomer in the copolymer may be alpha-olefin of 3 to 20 carbon atoms, particularly, propylene, 1-butene, 1-pentene, 4-methyl-1-pentene, 1-hexene, 1-heptene, 1-octene, 1-decene, 1-undecene, 1-dodecene, 1-tetradecene, 1-hexadecene, 1-eicosene, etc., and any one among them or mixtures of two or more thereof may be used. Among them, the alpha-olefin may be 1-butene, 1-hexene or 1-octene, particularly, 1-butene, 1-hexene, or a combination thereof.

In addition, in the ethylene/alpha-olefin copolymer, the alpha-olefin content may be suitably selected in the range satisfying the physical conditions, particularly, greater than 0 mol% to 99 mol%, or 10 mol% to 50 mol%, without limitation.

In addition, the olefin-based copolymer may be an ethylene alpha-olefin copolymer having a volume resistance of 1.0 × 10¹⁵ Ω·cm or more, particularly, 3.0 × 10¹⁵ Ω·cm or more, 5.0 × 10¹⁵ Ω·cm, or 7.0 × 10¹⁵ Ω·cm or more. If the volume resistance of the olefin-based copolymer is too low, the volume resistance of the encapsulant composition for an optical device may not reach a suitable level after crosslinking, but if the volume resistance of the olefin-based copolymer satisfies the above value, the encapsulant composition for an optical device may show excellent volume resistance after crosslinking. The upper limit of the volume resistance of the olefin-based copolymer is not specifically limited, but can be, considering the volume resistance commonly shown by an olefin-based copolymer and the difficulty in the preparation of an olefin-based copolymer having high volume resistance, 9.9 × 10¹⁷ Ω·cm or less, 9.0 × 10¹⁷ Ω·cm or less, 7.0 × 10¹⁷ Ω·cm or less.

### [Encapsulant Composition for Optical Device]

The crosslinking agent composition for an olefin-based copolymer of the present invention may be used together with an olefin-based copolymer to form an encapsulant composition for an optical device. The present invention provides an encapsulant composition for an optical device, including an olefin-based polymer, and the crosslinking agent composition for an olefin-based copolymer.

The explanation on the olefin-based copolymer and the encapsulant composition for an optical device are the same as described above.

The olefin-based copolymer may be included in 80 to 99.5 parts by weight, particularly, 80 parts by weight or more, 82 parts by weight or more, 85 parts by weight or more, 86 parts by weight or more, 87 parts by weight or more, or 88 parts by weight or more to 99.5 parts by weight or less, 99 parts by weight or less, or 98.5 parts by weight or less on the basis of 100 parts by weight of the encapsulant composition for an optical device. If the amount included of the olefin-based copolymer in the encapsulant composition for an optical device is too small, appropriate mechanical properties such as tear resistance and tear strength of an encapsulant for an optical device may be difficult to show. If the olefin-based copolymer is included in the encapsulant composition for an optical device in the above-described range, appropriate mechanical properties as an encapsulant for an optical device may be shown.

The crosslinking agent composition for an olefin-based copolymer according to an embodiment of the present invention may be used in 0.5 parts by weight to 20 parts by weight on the basis of 100 parts by weight of the olefin-based copolymer. The crosslinking agent composition for an olefin-based copolymer may particularly be used in 0.5 parts by weight or more, 0.7 parts by weight or more, 0.8 parts by weight or more, 1 part by weight or more, 1.1 parts by weight or more, 1.2 parts by weight or more, 1.3 parts by weight or more, 1.4 parts by weight or more, or 1.5 parts by weight or more to 20 parts by weight or less, 18 parts by weight or less, 15 parts by weight or less, 10 parts by weight or less, 8 parts by weight or less, 6 parts by weight or less, 5 parts by weight or less, or 3 parts by weight or less on the basis of 100 parts by weight of the olefin-based copolymer. If the amount used of the crosslinking agent composition is too small with respect to the olefin-based copolymer, a crosslinking reaction is difficult to occur, and if the amount used of the crosslinking agent composition is too large, the volume resistance of an encapsulant for an optical device may be reduced. If the crosslinking agent composition is used in the above-described ratio with respect to the olefin-based copolymer, an encapsulant composition for an optical device, using the same may undergo an appropriate crosslinking reaction to form an encapsulant for an optical device, and the encapsulant for an optical device thus manufactured may show high volume resistance.

In the encapsulant composition for an optical device according to an embodiment of the present invention, the crosslinking auxiliary compound of Formula 1 may be included in 0.1 to 9 parts by weight on the basis of 100 parts by weight of the olefin-based copolymer. The crosslinking auxiliary compound of Formula 1 may particularly be included in 0.1 parts by weight or more, 0.2 parts by weight or more, 0.3 parts by weight or more, or 0.4 parts by weight or more to 9 parts by weight or less, 8 parts by weight or less, 7 parts by weight or less, 6 parts by weight or less, 5 parts by weight or less, 4 parts by weight or less, 3 parts by weight or less, or 2 parts by weight or less on the basis of 100 parts by weight of the olefin-based copolymer. If the crosslinking auxiliary compound of Formula 1 and the second crosslinking auxiliary compound are used together as the crosslinking auxiliary agents, the total amount may satisfy the above-described range. If the amount used of the crosslinking auxiliary agent is too small with respect to the olefin-based copolymer, it is difficult to induce a crosslinking reaction, and if the amount used of the crosslinking auxiliary agent is too large, the volume resistance of an encapsulant for an optical device may be reduced. If the crosslinking auxiliary agent is included in the above-described ratio with respect to the olefin-based copolymer, an encapsulant composition for an optical device may induce an appropriate crosslinking reaction to form an encapsulant for an optical device, and the encapsulant for an optical device thus formed may show high volume resistance.

In addition, the encapsulant composition for an optical device may additionally and suitably include various additives known in the art in addition to the above-described components according to applicable use.

As the additive, one or more additives selected from a light stabilizer, a UV absorbent and a thermal stabilizer may be used.

The light stabilizer may capture the active species of the photothermal initiation of a resin to prevent photooxidation according to the use of the composition applied. The type of the light stabilizer used is not specifically limited, and for example, known compounds such as a hindered amine-based compound and a hindered piperidine-based compound may be used.

According to the use, the UV absorbent may absorb ultraviolet rays from the sunlight, etc., transform into harmless thermal energy in a molecule, and play the role of preventing the excitation of the active species of photothermal initiation in the resin composition. Particular types of the UV absorbent used are not specifically limited, and for example, one or a mixture of two or more of benzophenone-based, benzotriazole-based, acrylnitrile-based, metal complex-based, hindered amine-based, inorganic including ultrafine particulate titanium oxide and ultrafine particulate zinc oxide UV absorbents, etc. may be used.

In addition, the thermal stabilizer may include a phosphor-based thermal stabilizer such as tris(2,4-di-tert-butylphenyl)phosphite, phosphorous acid, bis[2,4-bis(1,1-dimethylethyl)-6-methylphenyl]ethylester, tetrakis(2,4-di-tert-butylphenyl)[1,1-biphenyl]-4,4'-diylbisphosphonate and bis(2,4-di-tert-butylphenyl)pentaerythritol diphosphite; and a lactone-based thermal stabilizer such as the reaction product of 8-hydroxy-5,7-di-tert-butyl-furan-2-on and o-xylene, and one or two or more of them may be used.

The amounts of the light stabilizer, UV absorbent and/or thermal stabilizer are not specifically limited. That is, the amounts of the additives may be suitably selected considering the use of the resin composition, the shape or density of the additives, etc. Generally, the amounts may be suitably controlled in a range of 0.01 to 5 parts by weight on the basis of 100 parts by weight of the total solid content of the encapsulant composition for an optical device.

In addition, the encapsulant composition for an optical device may be utilized in various molded articles by molding by injection, extrusion, etc. Particularly, the composition may be used in various optoelectronic devices, for example, as an encapsulant for the encapsulation of a device in a solar cell, and may be used as an industrial material applied in a lamination process with heating, etc., without limitation.

In addition, the present invention provides an encapsulant film for an optical device, manufactured by using the encapsulant composition for an optical device.

The encapsulant film for an optical device according to an embodiment of the present invention may include a structure derived from an olefin-based copolymer and a crosslinking auxiliary compound of Formula 1.

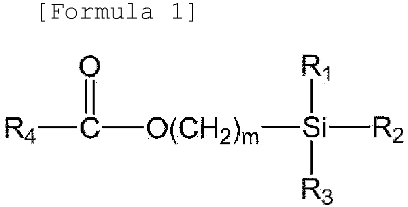

In Formula 1, R₁ to R₄ are each independently alkyl of 1 to 20 carbon atoms or alkenyl of 2 to 20 carbon atoms, and m is an integer of 1 to 20.

The explanation on the olefin-based copolymer and the crosslinking auxiliary compound of Formula 1 is the same as described above.

In addition, the encapsulant film for an optical device according to another embodiment of the present invention may include a structure derived from the crosslinking auxiliary compound of Formula 1 and the second crosslinking auxiliary compound.

The explanation on the second crosslinking auxiliary compound, and the explanation on a case in which the crosslinking auxiliary compound of Formula 1 and the second crosslinking auxiliary compound are used together as the crosslinking auxiliary agents are the same as described above.

In addition, the present invention provides an optoelectronic device including the encapsulant film for an optical device.

### Examples

Hereinafter, the present invention will be explained in more detail referring to embodiments. However, the embodiments are provided only for illustration, and the scope of the present invention is not limited thereto.

### Example 1

3-(Triallylsilyl)propyl acrylate [TPA, product of TCI Co. (Tokyo Chemical Industry Co., Ltd.)] and triallyl isocyanurate (TAIC, product of Sigma-Aldrich Co.) were mixed in 25 parts by weight and 75 parts by weight, respectively, to prepare a crosslinking auxiliary agent.

500 g of LUCENE^{™} LF675 of LG Chem, which is an ethylene/1-butene copolymer was dried using a convention oven of 40°C overnight. The density of the LUCENE^{™} LF675, measured based on ASTM D1505 was 0.877 g/cm², and the melt index (190°C, 2.16 kg) measured based on ASTM D1238 was 14.0 g/10 min. The bowl temperature of a Haake Modular Torque Viscometer was set to 40°C. An ethylene/alpha-olefin copolymer was injected into the bowl, a crosslinking agent composition [1.00 part per hundred rubber (phr) of t-butyl 1-(2-ethylhexyl) monoperoxycarbonate (TBEC, product of Sigma Aldrich Co.) as a crosslinking agent, 0.50 phr of a mixture of the TPA prepared and TAIC (weight ratio of 50: 50) as a crosslinking auxiliary agent, and 0.20 phr of methacryloxypropyltrimethoxysilane (MEMO, product of Shinetsu Co.) as a silane coupling agent] was injected, using an electronic pipette. While stirring in 40 rpm at 40°C, the change of a torque value in accordance with time was observed, soaking was terminated when the torque value increased rapidly, and the soaking completion time of the crosslinking agent composition was measured.

After that, by using a soaking completed specimen, an encapsulant film of a sheet shape was formed by press molding into an average thickness of 0.5 mm at a low temperature (under conditions of 90-100°C of an extruder barrel temperature) at which high-temperature crosslinking was not achieved.

### Example 2

A crosslinking auxiliary agent was prepared by the same method as in Example 1 except for using 3-(triallylsilyl)propyl acrylate (TPA) and triallyl isocyanurate (TAIC) as crosslinking auxiliary agents, in a mixing ratio of 50 parts by weight and 50 parts by weight, respectively, and then, an encapsulant film was manufactured.

### Example 3

A crosslinking auxiliary agent was prepared by the same method as in Example 1 except for using 3-(triallylsilyl)propyl acrylate (TPA) and triallyl isocyanurate (TAIC) as crosslinking auxiliary agents, in a mixing ratio of 75 parts by weight and 25 parts by weight, respectively, and then, an encapsulant film was manufactured.

### Example 4

A crosslinking auxiliary agent was prepared by the same method as in Example 1 except for using only 3-(triallylsilyl)propyl acrylate (TPA) in an injection amount of 0.25 phr instead of 0.50 phr as a crosslinking auxiliary agent, and then, an encapsulant film was manufactured.

### Example 5

A crosslinking auxiliary agent was prepared by the same method as in Example 1 except for using only 3-(triallylsilyl)propyl acrylate (TPA) as a crosslinking auxiliary agent, and then, an encapsulant film was manufactured.

### Example 6

A crosslinking auxiliary agent was prepared by the same method as in Example 1 except for using 3-(triallylsilyl)propyl acrylate (TPA) and triallyl isocyanurate (TAIC) as crosslinking auxiliary agents, in a mixing ratio of 10 parts by weight and 90 parts by weight, respectively, and then, an encapsulant film was manufactured.

### Example 7

A crosslinking auxiliary agent was prepared by the same method as in Example 1 except for using 3-(triallylsilyl)propyl acrylate (TPA) and triallyl isocyanurate (TAIC) as crosslinking auxiliary agents, in a mixing ratio of 20 parts by weight and 80 parts by weight, respectively, and then, an encapsulant film was manufactured.

### Example 8

A crosslinking auxiliary agent was prepared by the same method as in Example 1 except for using 3-(triallylsilyl)propyl acrylate (TPA) and triallyl isocyanurate (TAIC) as crosslinking auxiliary agents, in a mixing ratio of 80 parts by weight and 20 parts by weight, respectively, and then, an encapsulant film was manufactured.

### Comparative Example 1

A crosslinking auxiliary agent was prepared by the same method as in Example 1 except for using only triallyl isocyanurate (TAIC) as a crosslinking auxiliary agent, and then, an encapsulant film was manufactured.

In Table 1 below, the crosslinking agent compositions used in Examples 1 to 8 and Comparative example 1 are shown.

**[Table 1]**

| | Crosslinking auxiliary agent | | | Crosslin king agent (phr) | Silane coupling agent (phr) |
|---|---|---|---|---|---|
| | Component | | (phr) | | |
| | TPA (parts by weight) | TAIC (parts by weight) | | | |
| Example 1 | 25 | 75 | 0.50 | 1 | 0.2 |
| Example 2 | 50 | 50 | 0.50 | 1 | 0.2 |
| Example 3 | 75 | 25 | 0.50 | 1 | 0.2 |
| Example 4 | 100 | - | 0.25 | 1 | 0.2 |
| Example 5 | 100 | - | 0.50 | 1 | 0.2 |
| Example 6 | 10 | 90 | 0.50 | 1 | 0.2 |
| Example 7 | 20 | 80 | 0.50 | 1 | 0.2 |
| Example 8 | 80 | 20 | 0.50 | 1 | 0.2 |
| Comparative Example 1 | - | 100 | 0.50 | 1 | 0.2 |

### Experimental Examples

Between two releasing films (thickness: about 100 µm), the encapsulant film with a thickness of 0.5 mm (10 cm × 10 cm) was put, and laminated and crosslinked in a vacuum laminator at a process temperature of 150°C for a process time of 20 minutes (vacuum for 5 minutes/pressurizing for 1 minute/maintaining the pressure for 14 minutes).

### (1) Soaking Rate

For each of Examples 1 to 8 and Comparative Example 1, the soaking completion times of a crosslinking agent measured are recorded in Table 2 below.

### (2) Volume Resistance

Measurement was conducted while applying a voltage of 1,000 V for 600 seconds by using an Agilent 4339B High-Resistance meter (product of Agilent Technologies, Kabushiki Kaisha) under conditions of a temperature of 23 ± 1°C and a humidity of 50 ± 3%.

### (3) Vulcanization Properties

Vulcanization properties were measured using a premier MDR of Alpha Technologies Co., based on ASTM D5280. A test was conducted at 150°C for 20 minutes, and a torque curve in accordance time was obtained. In this case, 150°C conditions correspond to a lamination temperature, and 20 minutes correspond to a lamination time. In addition, the vulcanization properties among the samples were relatively compared using the difference between the maximum torque (MH) and the minimum torque (ML), applied by the MDR for a corresponding time period.

### (4) Degree of Crosslinking

The crosslinked sheet was cut into a size of 3 × 3 mm² using scissors. The sides and bottom of a 200 mesh wire netting of 7 × 14 cm² were blocked using a staple. The sheet was injected into the wire netting, and the weight of the sheet injected was measured. The amount of the sheet was controlled to be 0.49 to 0.51 g. After injecting the sheet, the top of the wire netting was blocked using a staple, and the total weight of a sample was measured. To a 2 L cylinder reactor, a solution of 10 g of dibutyl hydroxytoluene (BHT) dissolved in 1,000 g of xylene was poured, and three to four samples were injected thereinto. The reactor was heated, and after 5 hours from a point of initiating boiling, refluxing was terminated. The samples in the reactor were taken out using a metal landing net and washed with xylene. The samples were dried in vacuum at 100°C overnight. The weights of the dried samples were measured, and the degree of crosslinking was calculated. The degree of crosslinking was determined by the average value of three to four samples refluxed in xylene.

Degree of crosslinking (%) = [(weight of sheet after refluxing)/(weight of sheet before refluxing)] x 100

**[Table 2]**

| | Soaking time | MDR | Crosslinking properties | |
|---|---|---|---|---|
| | (min) | MH-ML (dNm) | Volume resistance (Ω·cm) | Degree of crosslinking (%) |
| Example 1 | 42 | 3.69 | 2.0×10¹⁶ | 78.6 |
| Example 2 | 30 | 3.26 | 3.7×10¹⁶ | 75.4 |
| Example 3 | 23 | 2.91 | 4.4×10¹⁶ | 73.1 |
| Example 4 | 12 | 2.30 | 2.6×10¹⁶ | 70.9 |
| Example 5 | 17 | 2.61 | 5.1×10¹⁶ | 70.2 |
| Example 6 | 51 | 3.74 | 1.9×10¹⁶ | 78.2 |
| Example 7 | 45 | 3.64 | 1.9×10¹⁶ | 77.8 |
| Example 8 | 21 | 2.89 | 4.5×10¹⁶ | 72.8 |
| Comparative Example 1 | 60 | 3.79 | 1.8×10¹⁶ | 78.0 |

As confirmed in Table 2, if the crosslinking agent compositions including the crosslinking auxiliary compounds of Formula 1, in Examples 1 to 8 are used, the soaking completion time of the crosslinking agent can be reduced in contrast to Comparative Example 1 using triallyl isocyanurate as a crosslinking auxiliary agent. In addition, if a certain amount or more of the crosslinking auxiliary compound is included together with triallyl isocyanurate as the crosslinking auxiliary agent as in Examples 1 to 3 and 6 to 8, the soaking completion time of the crosslinking agent can be reduced, and a high degree of crosslinking and high volume resistance can be achieved.

## Claims

1. A crosslinking agent composition for an olefin-based copolymer, the composition comprising:
a crosslinking agent;
a silane coupling agent; and
a crosslinking auxiliary compound of the following Formula 1: 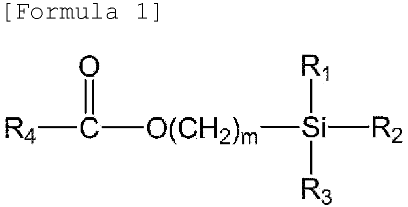 in Formula 1,
R₁ to R₄ are each independently alkyl of 1 to 20 carbon atoms or alkenyl of 2 to 20 carbon atoms, and
m is an integer of 1 to 20.

2. The crosslinking agent composition for an olefin-based copolymer according to claim 1, wherein R₁ to R₄ are each independently alkenyl of 2 to 8 carbon atoms, and m is an integer of 1 to 12.

3. The crosslinking agent composition for an olefin-based copolymer according to claim 1, wherein R₁ to R₄ are each independently alkenyl of 2 to 8 carbon atoms, having a double bond at the terminal thereof.

4. The crosslinking agent composition for an olefin-based copolymer according to claim 1, wherein the crosslinking auxiliary compound of Formula 1 is 3-(triallylsilyl)propyl acrylate.

5. The crosslinking agent composition for an olefin-based copolymer according to claim 1, further comprising a second crosslinking auxiliary compound in addition to the crosslinking auxiliary compound of Formula 1.

6. The crosslinking agent composition for an olefin-based copolymer according to claim 5, wherein a weight ratio of the crosslinking auxiliary compound of Formula 1 and the second crosslinking auxiliary compound is 1: 0.2 to 1: 9.

7. The crosslinking agent composition for an olefin-based copolymer according to claim 5, wherein the second crosslinking auxiliary compound comprises one or more selected from the group consisting of triallyl isocyanurate, triallyl cyanurate, diallyl phthalate, diallyl fumarate, diallyl maleate, ethylene glycol diacrylate, ethylene glycol dimethacrylate and trimethylolpropane trimethacrylate.

8. The crosslinking agent composition for an olefin-based copolymer according to claim 1, wherein the crosslinking agent is one or two or more selected from the group consisting of an organic peroxide, a hydroperoxide and an azo compound.

9. The crosslinking agent composition for an olefin-based copolymer according to claim 1, wherein the crosslinking agent is one or more selected from the group consisting of t-butylcumylperoxide, di-t-butyl peroxide, di-cumyl peroxide, 2,5-dimethyl-2,5-di(t-butylperoxy)hexane, 2,5-dimethyl-2,5-di(t-butylperoxy)-3-hexyne, cumene hydroperoxide, diisopropyl benzene hydroperoxide, 2,5-dimethyl-2,5-di(hydroperoxy)hexane, t-butyl hydroperoxide, bis-3,5,5-trimethylhexanoyl peroxide, octanoyl peroxide, benzoyl peroxide, o-methylbenzoyl peroxide, 2,4-dichlorobenzoyl peroxide, t-butylperoxy isobutyrate, t-butylperoxy acetate, t-butylperoxy-2-ethylhexylcarbonate (TBEC), t-butylperoxy-2-ethylhexanoate, t-butylperoxy pyvalate, t-butylperoxy octoate, t-butylperoxyisopropyl carbonate, t-butylperoxybenzoate, di-t-butylperoxyphthalate, 2,5-dimethyl-2,5-di(benzoylperoxy)hexane, 2,5-dimethyl-2,5-di(benzoylperoxy)-3-hexyne, methyl ethyl ketone peroxide, cyclohexanone peroxide, azobisisobutyronitrile and azobis(2,4-dimethylvaleronitrile).

10. The crosslinking agent composition for an olefin-based copolymer according to claim 1, wherein the silane coupling agent is one or more selected from the group consisting of N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, γ-methacryloxypropyltrimethoxysilane, vinyltrimethoxysilane, vinyltriethoxysilane, 3-methacryloxypropyl methyldimethoxysilane, 3-methacryloxypropyl methyldiethoxysilane, 3-methacryloxypropyl triethoxysilane, and p-styryl trimethoxysilane.

11. An encapsulant composition for an optical device, the composition comprising:
an olefin-based copolymer; and
the crosslinking agent composition for an olefin-based copolymer of claim 1.

12. The encapsulant composition for an optical device according to claim 11, wherein the olefin-based copolymer is an ethylene alpha-olefin copolymer.

13. An encapsulant film for an optical device, the film comprising a structure derived from an olefin-based copolymer and a compound of the following Formula 1: 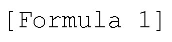 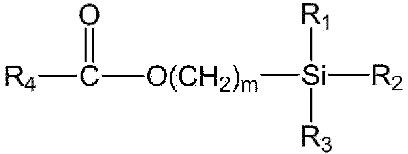 in Formula 1,
R₁ to R₄ are each independently alkyl of 1 to 20 carbon atoms or alkenyl of 2 to 20 carbon atoms, and
m is an integer of 1 to 20.

14. An optoelectronic device comprising an optical device, and the encapsulant film for an optical device according to claim 13.
